# EUROPEAN PATENT SPECIFICATION

(11) **EP 2 037 577 B1**
(45) Date of publication and mention of the grant of the patent: **15.01.2014**
(21) Application number: 07744849.6
(22) Date of filing: 07.06.2007
(51) Int. Cl.: H03H 7/46, H03H 9/72, H03H 9/05, H04B 1/18

(54) **Filter module and communication apparatus**
Filtermodul und Kommunikationsvorrichtung
Module de filtre et appareil de communication

(30) Priority: 05.07.2006 JP 2006185673
(43) Date of publication of application: 18.03.2009
(73) Proprietor: Murata Manufacturing Co. Ltd., Nagaokakyo-shi, Kyoto 617-8555 (JP)
(72) Inventor: HARADA, Tetsuro, Nagaokakyo-shi, Kyoto 617-8555 (JP)
(74) Representative: Zimmermann, Tankred Klaus
(86) International application number: PCT/JP2007/061519
(87) International publication number: WO 2008/004396

(56) References cited:
- EP-A1- 1 152 543
- EP-A1- 1 333 588
- EP-A1- 1 557 944
- WO-A2-2004/091109
- JP-A- 2001 044 702
- JP-A- 2002 198 855
- JP-A- 2004 166 258

## Description

### Technical Field

The present invention relates to filter modules for performing input/output of two signals in different frequency bands and to communication apparatuses having the filter modules.

### Background Art

Presently, there are various communication systems for mobile phones, such as GSM and DCS. Accordingly, devices for dual-band or triple-band applications compatible with a plurality of systems have been developed for mobile terminals. In such mobile terminals, switch circuits for switching systems to be used and filters for removing signals having frequencies other than operating frequencies.

Such a multi-band filter module which performs input/output of two signals in different frequency bands is disclosed in Patent Document 1.

Fig. 1 illustrates an example of a configuration of a filter module disclosed in Patent Document 1.

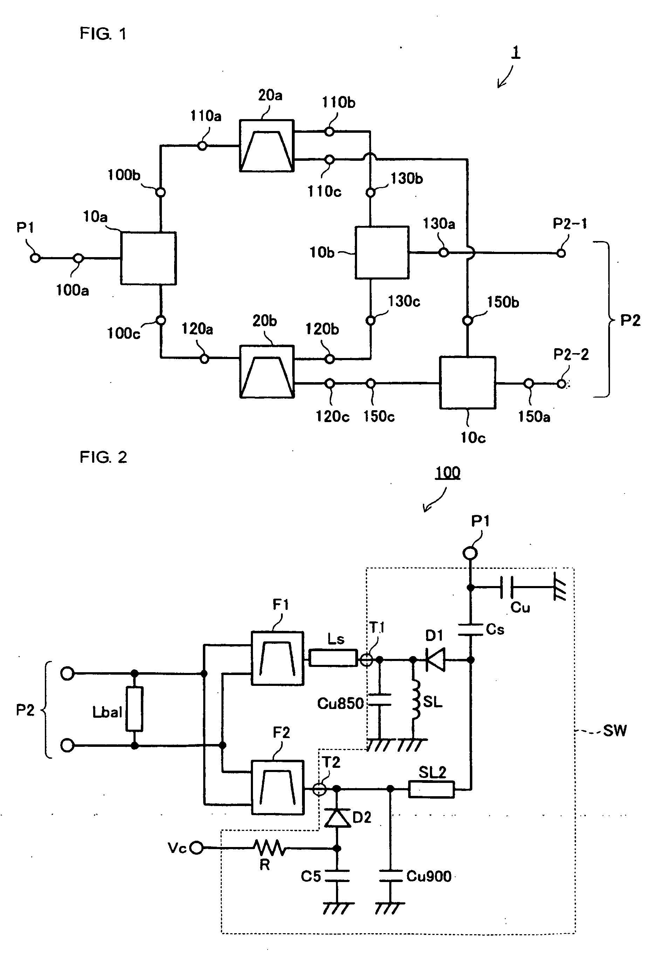

In Fig. 1, a first port 100a of a first high-frequency switch 10a is connected to an unbalanced port P1 of the filter module. This high-frequency switch 10a is a switch having three ports. A second port 100b of the first high-frequency switch 10a is connected to an unbalanced port 110a of a first balanced-unbalanced bandpass filter 20a. A third port 100c is connected to an unbalanced terminal 120a of a second balanced-unbalanced bandpass filter 20b. The first and second balanced-unbalanced bandpass filters 20a and 20b are connected to a second high-frequency switch 10b and a third high-frequency switch 10c each having three ports.

A first port 130a of the second high-frequency switch is connected to a first balanced port P2-1 of the filter module. A second port 130b of the second high-frequency switch is connected to a first balanced port 110b of the first balanced-unbalanced bandpass filter 20a. A third port 130c of the second high-frequency switch is connected to a first balanced port 120b of the second balanced-unbalanced bandpass filter 20b.

A first port 150a of the third high-frequency switch is connected to a second balanced port P2 of the filter module. A second port 150b of the third high-frequency switch is connected to a second balanced port 110c of the first balanced-unbalanced bandpass filter 20a. A third port 150c of the third high-frequency switch is connected to a second balanced port 120c of the second balanced-unbalanced bandpass filter 20b.
Patent Document 1: Japanese Unexamined Patent Application Publication No. 2004-166258

Further examples of multi-band filter modules and switch circuits for switching between communication systems are disclosed in patent documents WO 2004/091109, EP 1 152 543 and EP 1 333 588.

### Disclosure of Invention

### Problems to be solved by the invention

In a circuit disclosed in Patent Document 1, the two filters compatible with a plurality of systems and the first to third switches for switching these systems are used. Thus, communication is enabled by switching to either one of the filters for passing signals at communication frequencies to be operated.

Such a circuit has a problem of a large circuit scale since it requires the switches 10b and 10c at both the input and output sides.

To address this, it may be possible to provide a switch at only either input or output portion. However, with such a configuration in which switching is performed using only a switch circuit provided at the input side or output side of filters, signals leaked from the switch to a filter that is not selected by the switch may be transmitted. Thus, it is likely that signals at frequencies corresponding to the filter that is not selected are leaked. Therefore, there is a possibility of a communication failure or the like due to unwanted signals leaked into a currently operating system from another system.

Accordingly, an object of the present invention is to provide a filter module which overcomes the problem of leakage of unwanted signals from a signal path for use in a communication system not in operation among two communication systems for different frequency bands while the other communication system is engaged in communication, which enhances the selectivity. In addition, an object of the present invention is to provide a communication apparatus having the filter module.

### Means for Solving the Problems

(1) A filter module according to the present invention comprises a first port (P1); a second port (P2); a switch circuit having first and second input/output portions (T1)(T2) and a common input/output portion connected to the first port (P1), the switch circuit (SW) being configured to transmit a signal either between the first input/output portion (T1) and the first port (P1) or between the second input/output portion (T2) and the first port (P1), depending on a control voltage (Vc); a first filter for passing a signal in a first frequency band, the first filter being provided between the first input/output portion (T1) of the switch circuit and the second port (P2); and a second filter for passing a signal in a second frequency band, the second filter being provided between the second input/output portion (T2) of the switch circuit and the second port (P2). In the filter module, an impedance in the second frequency band which is seen from the first port (P1) while the switch circuit selects the first input/output portion is in a substantially short-circuited state.
(2) The first and second filters have a function of conversion between a balanced signal and an unbalanced signal. The second port is a balanced terminal. The first and second filters input and output signals to and from the second port in a balanced state.
(3) The switch circuit is integrated into a laminate composed of a plurality of dielectric layers. The first and second filters are surface acoustic wave filters or thickness extensional vibration piezoelectric filters mounted on the laminate.
(4) A phase adjusting circuit is provided between the first input/output portion (T1) of the switch circuit and the first filter, such that an impedance in the second frequency band seen from the first port (P1) while the switch circuit selects the first input/output portion is in a substantially short circuited state.
(5) The phase adjusting circuit includes any one of a transmission line, a capacitor, and an inductor.
(6) The switch circuit includes a capacitor and an inductor. The phase adjusting circuit is formed of a transmission line. The transmission line of the phase adjusting circuit is disposed on a layer different from a layer having formed thereon the capacitor or the inductor of the switch circuit when surfaces of the laminate are perspectively viewed in the lamination direction of the dielectric layers.
(7) A communication apparatus having the filter module in a high-frequency circuit part.

### Advantages

(1) Since the impedance in the second frequency band which is seen from the first port while the switch circuit selects the first input/output portion is in a substantially short-circuited state, a signal leaked from the second filter and the switch circuit and transmitted is short-circuited and hardly passes through between the first port and the second port. Thus, the selectivity of signals in the first and second frequency bands can be enhanced.
(2) By employing filters having a balanced to unbalanced conversion function as the first and second filters, balanced input and output of a signal can be performed without using a balanced to unbalanced transformer such as a balun. Thus, downsizing of the entire module can be realized.
(3) The switch circuit is integrated into a laminate composed of a plurality of dielectric layers, and the first and second filters formed of surface acoustic wave filters or thickness extensional vibration piezoelectric filters are mounted on the laminate. This configuration permits fabrication of a filter module with a reduced size and high frequency selectivity.
(4) A phase adjusting circuit is provided between the first input/output portion of the switch circuit and the first filter, such that an impedance in the second frequency band seen from the first port while the switch circuit selects the first input/output portion is in a substantially short-circuited state. This phase adjusting circuit rotates the impedance seen from the first port on a Smith chart and can easily bring the impedance close to a short circuit. Therefore, pass-through of signals leaked from the second filter and the switch circuit can be effectively suppressed.
(5) The phase adjusting circuit includes any one of a transmission line, a capacitor, and an inductor. This facilitates mounting of the phase adjusting circuit together with elements constituting the switch circuit. Thus, a size increase due to the mounting of the phase adjusting circuit can be prevented.
(6) The transmission line, which is the phase adjusting circuit, is disposed on a layer different from a layer having the capacitor or the inductor of the switch circuit when surfaces of the laminate are perspectively viewed in the lamination direction of the dielectric layers. With this arrangement, the capacitor and inductor, and the transmission line of the phase adjusting circuit do not adversely affect each other, and downsizing of the entire module can be realized.
(7) A small size, low cost communication apparatus processing a plurality of communication signals having different frequency bands can be fabricated by providing the filter module in its high-frequency circuit part.

### Brief Description of the Drawings

Fig. 1 is a diagram illustrating a configuration of a filter module disclosed in Patent Document 1.
Fig. 2 is a circuit diagram of a filter module according to a first embodiment.
Fig. 3 shows a characteristic diagram obtained when a phase adjusting circuit of the filter module is not provided.
Fig. 4 shows a characteristic diagram obtained when a phase adjusting circuit of the filter module is provided.
Fig. 5 shows diagrams illustrating conductor patterns of individual dielectric layers when the filter module is constituted by a laminate of the dielectric layers.
Fig. 6 shows diagrams illustrating conductor patterns of individual dielectric layers when the filter module is constituted by a laminate of the dielectric layers.
Fig. 7 shows diagrams illustrating conductor patterns of individual dielectric layers when the filter module is constituted by a laminate of the dielectric layers.
Fig. 8 is a circuit diagram illustrating a filter module according to a second embodiment.
Fig. 9 shows diagrams illustrating conductor patterns of individual dielectric layers when the filter module is constituted by a laminate of the dielectric layers.
Fig. 10 shows diagrams illustrating conductor patterns of individual dielectric layers when the filter module is constituted by a laminate of the dielectric layers.
Fig. 11 shows diagrams illustrating conductor patterns of individual dielectric layers when the filter module is constituted by a laminate of the dielectric layers.
Fig. 12 is a diagram illustrating a configuration of a communication apparatus according to a third embodiment.

### Reference Numerals

- 100: filter module
- F1: first filter
- F2: second filter
- Ls: phase adjusting circuit
- Z: phase adjusting circuit
- P1: first port
- P2: second port
- T1: first input/output portion
- T2: second input/output portion

### Best Mode for Carrying Out the Invention

### <First Embodiment>

Fig. 2 is a circuit diagram illustrating a filter module according to a first embodiment. This filter module 100 has a first input/output port P1 for inputting and outputting a signal in an unbalances state, a second input/output port P2 for inputting and outputting a signal in a balanced state, and a control terminal Vc for switching frequency bands. The filter module 100 is generally composed of a first filter F1, a second filter F2, and a switch circuit SW.

The switch circuit SW has a common input/output portion connected to the first port P1, a first input/output portion T1, and a second input/output portion T2. The first filter F1 passes a signal in a first frequency band (850 MHz) and is provided between the first input/output portion T1 of the switch circuit SW and the second port P2. The second filter F2 passes a signal in a second frequency band (900 MHz) and is provided between the second input/output portion T2 of the switch circuit SW and the second port P2.

A phase adjusting circuit Ls is provided between the first input/output portion T1 and the first filter F1. A matching element (inductor) Lbal is provided between balanced terminals of the second port P2.

A diode D1 is proved in series between the first input/output portion T1 of the switch circuit SW and the first port P1 via a capacitor Cs. An inductor SL serving as a path for applying a direct current control voltage and a capacitor Cu850 which resonates with the inductor SL are provided between the cathode side of the diode D1 and ground. A capacitor Cu for providing matching is provided at the first port P1.

A diode D2 is provided between the second input/output portion T2 and ground and is connected to a shunt via a capacitor C5. In addition, a capacitor Cu900 for providing matching is connected between the second input/output portion T2 and ground. A stripline SL2 having an electrical length of a quarter wavelength in the 850 MHz band is provided between the connection point of the anode of the diode D1 and the capacitor Cs, and the cathode of the diode D2.

A resistor R is connected between the control terminal Vc and the anode of the diode D2. When a voltage applied to the control terminal Vc is 0V, both the diodes D1 and D2 are OFF, which allows a signal to be transmitted between the second input/output portion T2 and the first port P1. When a predetermined positive voltage is applied to the control terminal Vc, both the diodes D1 and D2 are turned on, allowing a signal to be transmitted between the first input/output portion T1 and the first port P1.

In this way, by simply providing the single switch circuit SW, signals to pass through the filters F1 and F2 can be switched. However, a signal attempting to pass through a filter that is not selected by the switch circuit SW may be leaked from the switch circuit SW. As a result, a signal at an unwanted frequency is likely to pass through the filter.

For example, when the diodes D1 and D2 are ON, i.e., when the switch circuit SW selects the first input/output portion T1, and a GSM850 signal is input from the first port P1 and output from the second port P2, a signal in the 900 MHz band may be leaked from the switch circuit SW. The signal in the 900 MHz band may then pass through the second filter F2 and be leaked into the second port P2, although the amount of thereof is slight. As a result, the GSM900 signal is superimposed on the GSM850 signal.

Also in the case where a signal is transmitted from the second port P2 to the first port P1, pass-through of a signal corresponding to a filter that is not selected by the switch circuit SW and leakage from the switch circuit SW occur. Thus, a signal at an unwanted frequency is likely to pass.

The phase adjusting circuit Ls in Fig. 2 is provided to overcome the above problem associated with the pass-through of signals at unwanted frequencies. When a signal in the 900 MHz band is input from the first port P1, this signal is not to pass through the first filter F1 and is to be reflected toward the first port P1. The phase of this reflected signal is adjusted by the phase adjusting circuit Ls. The phase adjusting circuit Ls performs phase adjustment such that the impedance in the 900 MHz obtained when this filter module is seen from the first port P1 while the switch circuit SW selects the first input/output portion T1 is in a substantially short-circuited state.

In this way, if the impedance at a predetermined frequency in the second frequency band (900 MHz) is in a substantially short-circuited state when this filter module is seen from the first port P1 while the switch SW selects the first input/output portion T1, signal components in the 900 MHz band attempting to pass through the leakage of the second filter F2 and the switch circuit SW are suppressed.

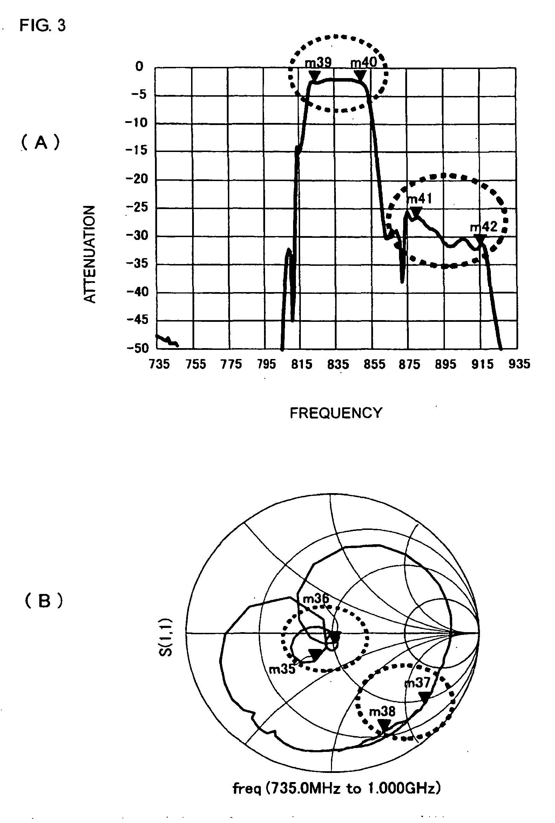

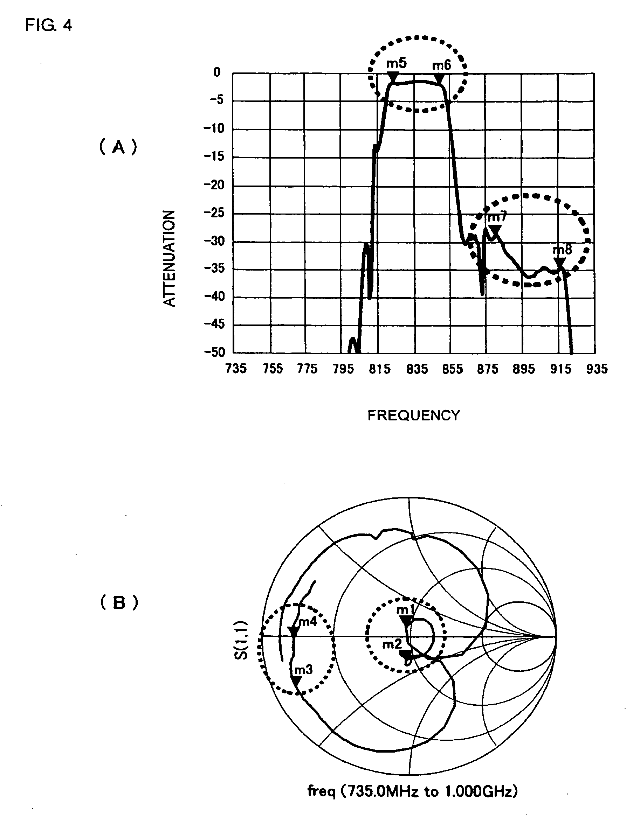

Fig. 3 and Fig. 4 illustrate the effects of the phase adjusting circuit Ls. Fig. 3 shows a characteristic diagram obtained when the phase adjusting circuit Ls is not provided. Fig. 4 shows a characteristic diagram obtained when the phase adjusting circuit Ls is provided.

Fig. 3(A) and Fig. 4(A) show transmission characteristics between the first port P1 and the second port P2. Fig. 3(B) and Fig. 4(B) are diagrams each illustrating a reflection characteristic obtained when this filter module is seen from the first port P1, i.e., a reflection coefficient S(1, 1) in the S parameter, is expressed by a Smith chart (impedance chart) (impedance locus obtained by frequency sweeping).

Points m39, m35, m5, and m1 shown in Fig. 3 and Fig. 4 all indicate values at 824 MHz. Points m40, m36, m6, and m2 all indicate values at 849 MHz. Points m41, m37, m7, and m3 all indicate values at 880 MHz. Further, points m42, m38, m8, and m4 all indicate values at 915 MHz.

As is apparent from comparison of Fig. 3(B) and Fig. 4(B), by providing the phase adjusting circuit Ls, the impedance locus on the Smith chart rotates clockwise by a predetermined angle (120 degrees in this example). As shown in Fig. 4(B), signal components in the 900 MHz band are suppressed by phase adjustment performed such that the impedance in the 900 MHz band to be attenuated is substantially a short-circuited state, i.e., near the left end of the Smith cart. In this example, as expressed in the transmission characteristics shown in Fig. 3(A) and Fig. 4(A), it can be seen that the attenuation in the 900 MHz band (center frequency about 898 MHz) is improved by approximately 3 dB.

On the other hand, since the first filter F1 passes signals in the 850 MHz band, the impedance in this frequency band is located around the reference impedance (the center on the Smith chart) and thus is hardly affected by the phase adjustment performed by the phase adjusting circuit Ls. As can also be seen from the transmission characteristics shown in Fig. 3(A) and Fig. 4(A), the insertion loss in the 850 MHz band (center frequency about 837 MHz) is not degraded.

The above phase adjusting circuit Ls operates similarly for signals transmitted from the second port P2 to the first port P1. Specifically, among signals input from the second port P2, a 900 MHz band component passes through the second filter. However, such a component is substantially equivalently short-circuited at the output terminal of the switch circuit SW, and thus 900 MHz band signals can be suppressed.

In the example shown in Fig. 2, the phase adjusting circuit Ls is provided between the first input/output portion T1 of the switch circuit SW and the first filter F1. However, such an independent phase adjusting circuit Ls is not necessary as long as the impedance at a predetermined frequency in the second frequency band obtained when this filter module is seen from the first port P1 while the switch circuit SW currently selects the first input/output portion T1 is in a substantially short-circuited state. In other words, this condition can be satisfied by appropriately setting an electrical length from the switch circuit SW to the first filter F1 and a circuit configuration of the switch circuit.

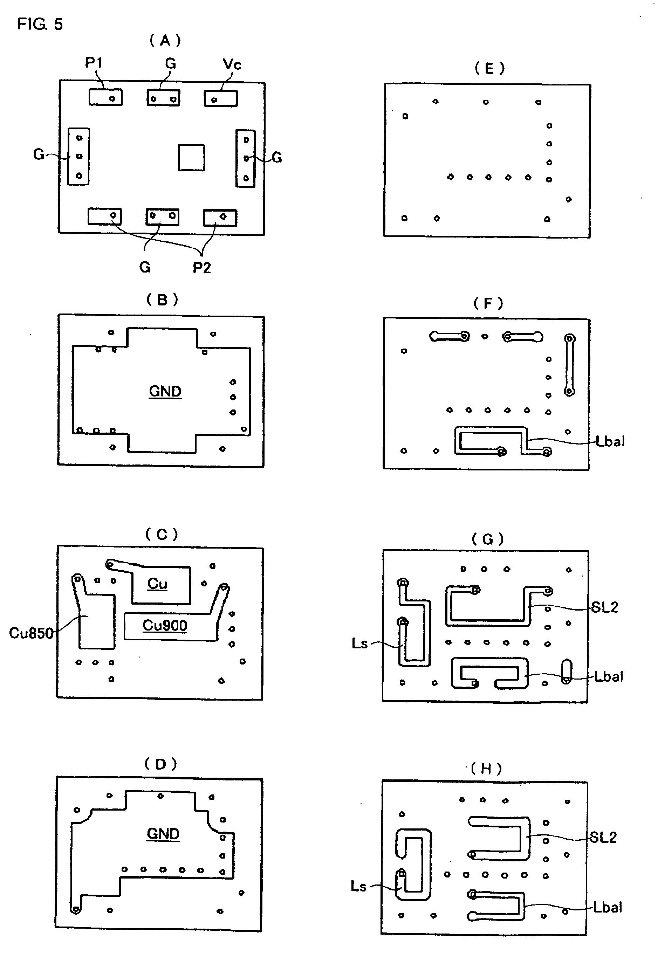

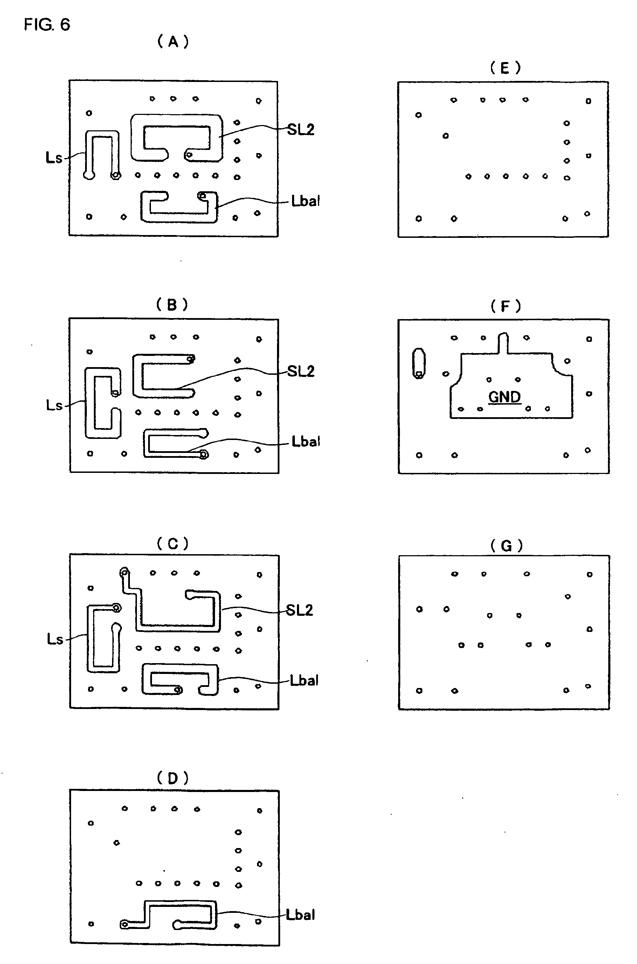

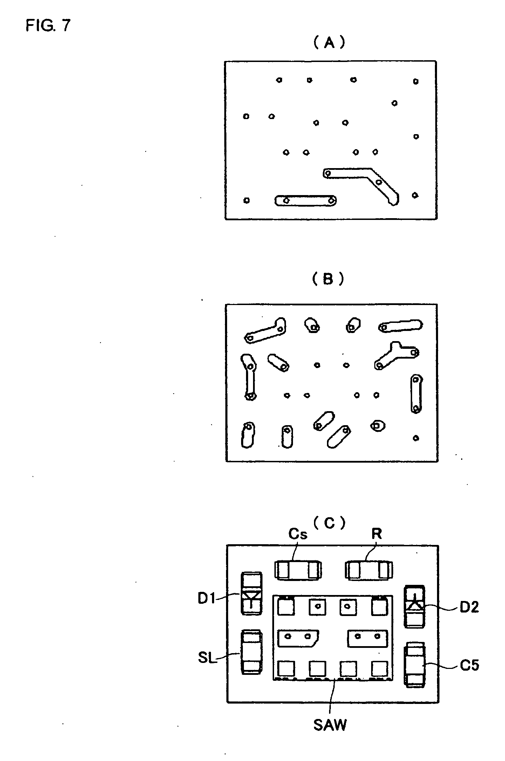

Fig. 5 to Fig. 7 are diagrams illustrating a configuration of the above filter module when it is integrated into a laminate of dielectric layers. Each of the diagrams is a plan view of a conductor pattern on the lower surface of each of a plurality of dielectric layers. Fig. 5(A) shows the bottom layer, and Fig. 7(B) shows the top layer. Fig. 7(C) is a plan view of the upper surface of the top layer mounted with individual chips. For convenience of illustration, these layers are illustrated in three figures from Fig. 5 to Fig. 7. In Fig. 5 to Fig. 7, GND indicates a ground electrode.

In Fig. 5(A), P1 indicates a terminal of the first port, P2 indicates terminals of the second port, G indicates a ground terminal, and Vc indicates a control terminal.

Conductor patterns Cu, Cu900, and Cu850 in Fig. 5(C) are opposed to the ground electrodes GND in Figs. 5(B) and (D) and constitute the capacitors Cu, Cu900, and Cu850, respectively.

As illustrated in Fig. 7(C), a surface acoustic wave filter SAW in which the first filter F1 passing the 850 MHz band and the second filter F2 passing the 900 MHz are integrated as one device, a chip inductor SL, chip capacitors Cs and C5, diodes D1 and D2 and a chip resistor R are mounted on the upper surface of the laminate.

Note that a thickness extensional vibration piezoelectric (BAW) filter may be used in place of the surface acoustic wave filter.

### <Second Embodiment>

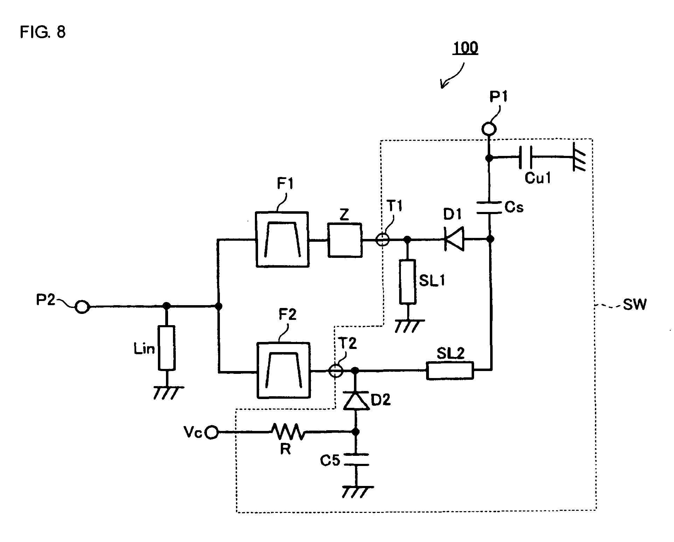

Fig. 8 is a circuit diagram of a filter module according to a second embodiment. This filter module 100 has a first input/output port P1 for inputting and outputting a signal in an unbalanced state, a second input/output port P2 for inputting and outputting a signal in an unbalanced state, and a control terminal Vc for switching frequency bands. The filter module 100 is generally composed of a first filter F1, a second filter F2, and a switch circuit SW.

The switch circuit SW has a common input/output portion connected to the first port P1, a first input/output portion T1, and a second input/output portion T2. The first filter F1 passes a signal in a first frequency band (850 MHz) and is provided between the first input/output portion T1 of the switch circuit SW and the second port P2. The second filter F2 passes a signal in a second frequency band (900 MHz) and is provided between the second input/output portion T2 of the switch circuit SW and the second port P2.

A phase adjusting circuit Z is provided between the first input/output portion T1 and the first filter F1. A matching element (inductor) Lin is provided between the second port P2 and ground.

A diode D1 is proved in series between the first input/output portion T1 of the switch circuit SW and the first port P1 via a capacitor Cs. A stripline SL1 serving as a path for applying a direct current control voltage is provided between the cathode side of the diode D1 and ground. A capacitor Cu1 for providing matching is provided at the first port P1.

A Diode D2 is provided between the second input/output portion T2 and ground and is connected to a shunt via a capacitor C5. A stripline SL2 for phase adjustment is provided between the connection point of the anode of the diode D1 and the capacitor Cs, and the cathode of the diode D2.

A resistor R is connected between the control terminal Vc and the anode of the diode D2. When a voltage applied to the control terminal Vc is 0V, both the diodes D1 and D2 are OFF, which allows a signal to be transmitted between the second input/output portion T2 and the first port P1. When a predetermined positive voltage is applied to the control terminal Vc, both the diodes D1 and D2 are turned on, allowing a signal to be transmitted between the first input/output portion T1 and the first port P1.

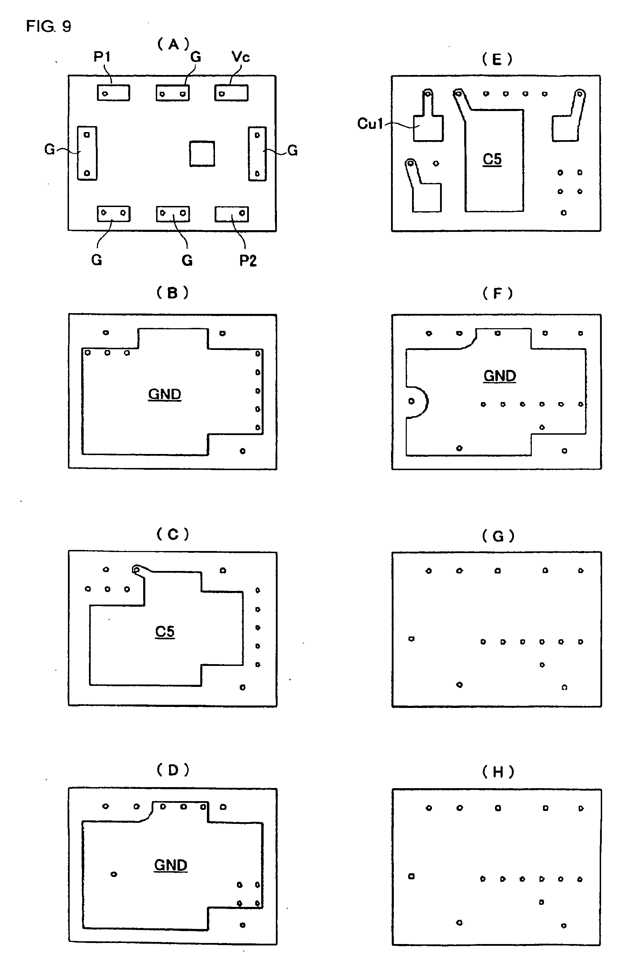

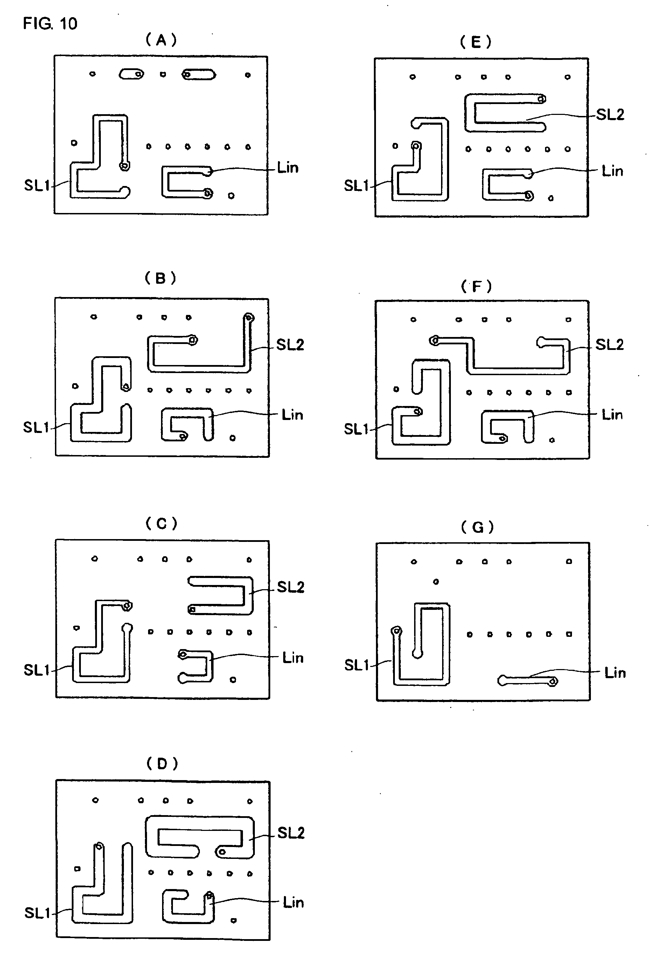

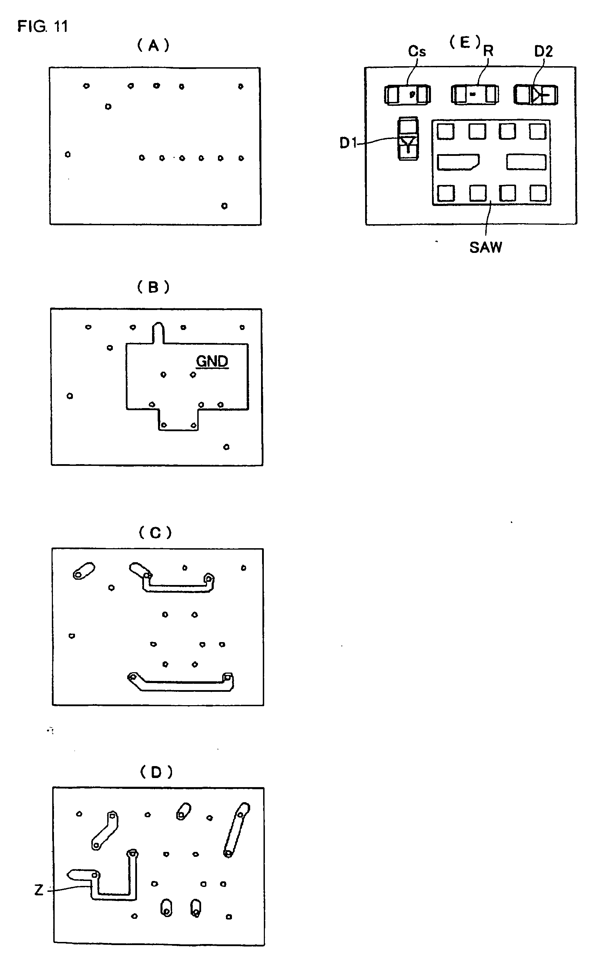

Fig. 9 to Fig. 11 shows diagrams illustrating a configuration of the above filter module when it is integrated into a laminate of a dielectric layers. Each of the diagrams is a plan view of a conductor pattern on the lower surface of each of a plurality of dielectric layers. Fig. 9(A) shows the bottom layer, and Fig. 11(D) shows the top layer. Fig. 11(E) is a plan view of the upper surface of the top layer mounted with individual chips. For convenience of illustration, these layers are illustrated in three figures from Fig. 9 to Fig. 11. In Fig. 9 to Fig. 11, reference signs in the figures correspond to the reference signs in the circuit shown in Fig. 8. In addition, GND indicates a ground electrode.

In Fig. 9(A), P1 indicates a terminal of the first port, P2 indicates a terminal of the second port, G indicates a ground terminal, and Vc indicates a control terminal.

Conductor patterns C5 in Figs. 9(C) and (E) are opposed to the ground electrodes GND in Figs. 9(B), (D) and (F) and form the capacitor C5.

As illustrated in Fig. 11(E), a surface acoustic wave filter SAW in which the first filter F1 for passing the 850 MHz band and the second filter F2 for passing the 900 MHz band are integrated as one device, a chip capacitor Cs, diodes D1 and D2, and a chip resistor R are mounted on the upper surface of the laminate.

A phase adjusting circuit Z formed of a transmission line is provided on the layer shown in Fig. 11(D). This phase adjusting circuit Z is disposed on a layer independent of layers having capacitors and inductors constituting the switch circuit SW. Thus, the various elements of the switch circuit do not give adverse effects on the phase adjusting circuit Z, and this phase adjusting circuit Z does not affect other circuits. Thus preset phase adjustment is enabled.

In the first and second embodiments, the phase adjusting circuit is formed of a transmission line connected in series with a signal transmission path. However, other configurations can also be employed. For example, the phase adjustment may also be configured by providing a capacitor connected to a shunt between a line and ground. It is also possible to combine both of these configurations. Further, instead of the configuration in which a transmission line a capacitor, an inductor, or the like constituting the phase adjusting circuit, is formed as a conductive pattern in a laminate of dielectric layers, the phase adjusting circuit may be configured by mounting a chip inductor and a chip capacitor on the laminate.

In addition, in the examples described in the first and second embodiment, pass-through of signals in the 900 MHz band is suppressed while the 850 MHz is selected. However, in contrast, the embodiments may be similarly applied when a phase adjusting circuit is provided between the second filter F2 passing the 900 MHz band and the switch circuit SW, so that the pass-through of signals in the 850 MHz band is suppressed while the 900 MHz band is selected.

### <Third Embodiment>

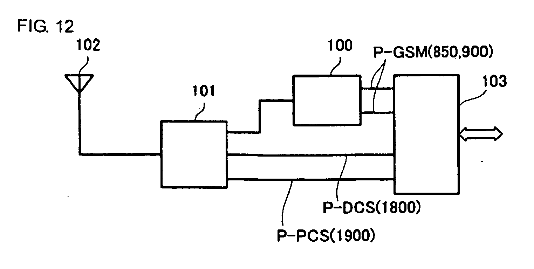

Fig. 12 illustrates a configuration of a high-frequency circuit part of a quadband mobile phone. This high-frequency circuit part is composed of a triple-band chip set 103, a balanced-unbalanced filter module 100, a triple-band antenna switch module 101, and an antenna 102. The antenna switch module 101 is an antenna switch for GSM900/DCS1800/PCS1900, and the antenna 102 is shared for these frequency bands. The filter module 100 is connected to a GSM port, and GSM850 and GSM900 are switched using this filter module 100. The triple-band chip set 103 is a chip set for GSM900/DCS1800/PCS1900 and operates as an RF (high-frequency) front-end circuit for these three bands. It is also possible to configure a mobile phone by connecting a baseband chip (not shown) to the triple-band chip set 103 and further providing an input/output portion in the baseband chip.

In this example, the balanced input/output port of the filter module 100 is indicated by two terminals since it performs balanced input/output for GSM850 and GSM900.

In this way, a quadband mobile phone device can be easily configured by forming a high-frequency circuit in which the triple-band chip set 103 and the filter module 100 described in the first embodiment are combined.

## Claims

1. A filter module comprising
a first port (P1);
a second port (P2);
a switch circuit (SW) having first and second input/output portions (T1, T2) and a common input/output portion,
the common input/output portion being connected to the first port (P1),
the switch circuit (SW) being configured to transmit a signal either between the first input/output portion (T1) and the first port (P1) or between the second input/output portion (T2) and the first port (P1), depending on a control voltage (Vc);
a first filter (F1) provided between the first input/output portion (T1) of the switch circuit (SW) and the second port (P2), the first filter (F1) passing a signal in a first frequency band, and
a second filter (F2) provided between the second input/output portion (T2) of the switch circuit (SW) and the second port (P2), the second filter (F2) passing a signal in a second frequency band,
**characterized in that** an impedance in the second frequency band which is seen from the first port (P1) while the switch circuit (SW) selects the first input/output portion (T1) is in a substantially short-circuited state.

2. The filter module according to claim 1, wherein the first and second filters (F1, F2) have a function of conversion between a balanced signal and an unbalanced signal, wherein the second port (P2) is a balanced terminal, and wherein the first and second filters (F1, F2) input and output signals to and from the second port (P2) in a balanced state.

3. The filter module according to claim 1 or 2, wherein the switch circuit (SW) is integrated into a laminate composed of a plurality of dielectric layers, and wherein the first and second filters (F1, F2) are surface acoustic wave filters or thickness extensional vibration piezoelectric filters mounted on the laminate.

4. The filter module according to any one of claims 1 to 3, wherein a phase adjusting circuit (Ls; Z) is provided between the first input/output portion (T1) of the switch circuit (SW) and the first filter (F1), the phase adjusting circuit (Ls; Z) causing an impedance in the second frequency band seen from the first port (P1) while the switch circuit (SW) selects the first input/output portion (T1) to be close to a short circuit.

5. The filter module according to claim 4, wherein the phase adjusting circuit (Ls) includes any one of a transmission line, a capacitor, and an inductor.

6. The filter module according to claim 4, wherein the switch circuit (SW) includes a capacitor and an inductor, wherein the phase adjusting circuit (Ls) is formed of a transmission line, and wherein the transmission line of the phase adjusting circuit is disposed on a layer different from a layer having formed thereon the capacitor or the inductor of the switch circuit (SW) when surfaces of the laminate are perspectively viewed in the lamination direction of the dielectric layers.

7. A communication apparatus having the filter module according to any one of claims 1 to 6 in a high-frequency circuit part.

## Patentansprüche

1. Ein Filtermodul, das folgende Merkmale aufweist:
ein erstes Tor (P1);
ein zweites Tor (P2);
eine Schalterschaltung (SW) mit einem ersten und einem zweiten Eingabe/Ausgabeabschnitt (T1, T2) und einem gemeinsamen Eingabe/Ausgabeabschnitt, wobei der gemeinsame Eingabe/Ausgabeabschnitt mit dem ersten Tor (P1) verbunden ist, wobei die Schalterschaltung (SW) konfiguriert ist, um ein Signal entweder zwischen dem ersten Eingabe/Ausgabeabschnitt (T1) und dem ersten Tor (P1) oder zwischen dem zweiten Eingabe/Ausgabeabschnitt (T2) und dem ersten Tor (P1) zu schalten, abhängig von einer Steuerspannung (Vc);
ein erstes Filter (F1), das zwischen dem ersten Eingabe/Ausgabeabschnitt (T1) der Schalterschaltung (SW) und dem zweiten Tor (P2) vorgesehen ist, wobei das erste Filter (F1) ein Signal in einem ersten Frequenzband durchlässt,
ein zweites Filter (F2), das zwischen dem zweiten Eingabe/Ausgabeabschnitt (T2) der Schalterschaltung (SW) und dem zweiten Tor (P2) vorgesehen ist, wobei das zweite Filter (F2) ein Signal in einem zweiten Frequenzband durchlässt,
**dadurch gekennzeichnet, dass** eine Impedanz in dem zweiten Frequenzband, die von dem ersten Tor (P1) aus gesehen wird, während die Schalterschaltung (SW) den ersten Eingabe/Ausgabeabschnitt (T1) auswählt, im Wesentlichen in einem Kurzschlusszustand ist.

2. Das Filtermodul gemäß Anspruch 1, bei dem das erste und zweite Filter (F1, F2) eine Funktion der Umwandlung zwischen einem symmetrischen Signal und einem unsymmetrischen Signal aufweisen, wobei das zweite Tor (P2) ein symmetrischer Anschluss ist, und wobei das erste und zweite Filter (F1, F2) Signale eingeben in und ausgeben von dem zweiten Tor (P2) in einem symmetrischen Zustand.

3. Das Filtermodul gemäß Anspruch 1 oder 2, bei dem die Schalterschaltung (SW) in ein Laminat integriert ist, das aus einer Mehrzahl von dielektrischen Schichten zusammengesetzt ist, und wobei das erste und zweite Filter (F1, F2) Oberflächenwellenfilter oder in der Dicke dehnbare schwingende piezoelektrische Filter sind, die auf dem Laminat befestigt sind.

4. Das Filtermodul gemäß einem der Ansprüche 1 bis 3, bei dem eine Phaseneinstellschaltung (Ls; Z) zwischen dem ersten Eingabe/Ausgabeabschnitt (T1) der Schalterschaltung (SW) und dem ersten Filter (F1) vorgesehen ist, wobei die Phaseneinstellschaltung (Ls; Z) eine Impedanz verursacht in dem zweiten Frequenzband gesehen von dem ersten Tor (P1), während die Schalterschaltung (SW) den ersten Eingabe/Ausgabeabschnitt (T1) so wählt, dass derselbe nahe einem Kurzschluss ist.

5. Das Filtermodul gemäß Anspruch 4, bei dem die Phaseneinstellschaltung (Ls) entweder eine Übertragungsleitung, einen Kondensator oder einen Induktor umfasst.

6. Das Filtermodul gemäß Anspruch 4, bei dem die Schalterschaltung (SW) einen Kondensator und einen Induktor umfasst, wobei die Phaseneinstellschaltung (Ls) aus einer Übertragungsleitung gebildet ist, und wobei die Übertragungsleitung der Phaseneinstellschaltung auf einer Schicht angeordnet ist, die sich von einer Schicht unterscheidet, auf der der Kondensator oder der Induktor der Schalterschaltung (SW) gebildet sind, wenn Oberflächen des Laminats perspektivisch gesehen werden in der Laminierungsrichtung der dielektrischen Schichten.

7. Eine Kommunikationsvorrichtung mit dem Filtermodul gemäß einem der Ansprüche 1 bis 6 in einem Hochfrequenzschaltungsteil.

## Revendications

1. Module de filtres comprenant :
un premier port (P1) ;
un deuxième port (P2) ;
un circuit de commutation (SW) comportant des première et deuxième parties d'entrée/sortie (T1, T2) et une partie d'entrée/sortie commune, la partie d'entrée/sortie commune étant connectée au premier port (P1), le circuit de commutation (SW) étant configuré pour transmettre un signal soit entre la première partie d'entrée/sortie (T1) et le premier port (P1), soit entre la deuxième partie d'entrée/sortie (T2) et le premier port (P1), en fonction d'une tension de commande (Vc) ;
un premier filtre (F1) prévu entre la première partie d'entrée/sortie (T1) du circuit de commutation (SW) et le deuxième port (P2), le premier filtre (F1) laissant passer un signal dans une première bande de fréquence ; et
un deuxième filtre (F2) prévu entre la deuxième partie d'entrée/sortie (T2) du circuit de commutation (SW) et le deuxième port (P2), le deuxième filtre (F2) laissant passer un signal dans une deuxième bande de fréquence,
**caractérisé en ce qu'**une impédance dans la deuxième bande de fréquence qui est vue à partir du premier port (P1) alors que le circuit de commutation (SW) sélectionne la première partie d'entrée/sortie (T1) est sensiblement dans un état de court-circuit.

2. Module de filtres selon la revendication 1, dans lequel les premier et deuxième filtres (F1, F2) ont une fonction de conversion entre un signal symétrique et un signal non symétrique, dans lequel le deuxième port (P2) est une borne symétrique, et dans lequel les premier et deuxième filtres (F1, F2) entrent et sortent les signaux vers et du deuxième port (P2) dans un état symétrique.

3. Module de filtres selon la revendication 1 ou 2, dans lequel le circuit de commutation (SW) est intégré dans un stratifié composé d'une pluralité de couches diélectriques, et dans lequel les premier et deuxième filtres (F1, F2) sont des filtres à onde acoustique de surface ou des filtres piézoélectriques à vibration d'extension d'épaisseur montés sur le stratifié.

4. Module de filtres selon l'une quelconque des revendications 1 à 3, dans lequel un circuit d'ajustement de phase (Ls ; Z) est prévu entre la première partie d'entrée/sortie (T1) du circuit de commutation (SW) et le premier filtre (F1), le circuit d'ajustement de phase (Ls ; Z) amenant une impédance dans la deuxième bande de fréquence vue à partir du premier port (P1) alors que le circuit de commutation (SW) sélectionne la première partie d'entrée/sortie (T1) à tendre vers un court-circuit.

5. Module de filtres selon la revendication 4, dans lequel le circuit d'ajustement de phase (Ls) comprend l'un quelconque d'une ligne de transmission, d'un condensateur et d'une inductance.

6. Module de filtres selon la revendication 4, dans lequel le circuit de commutation (SW) comprend un condensateur et une inductance, dans lequel le circuit d'ajustement de phase (Ls) est constitué d'une ligne de transmission, et dans lequel la ligne de transmission du circuit d'ajustement de phase est disposée sur une couche différente d'une couche sur laquelle est formé le condensateur ou l'inductance du circuit de commutation (SW) lorsque les surfaces du stratifié sont vues en perspective dans la direction de lamification des couches diélectriques.

7. Appareil de communication comportant le module de filtres selon l'une quelconque des revendications 1 à 6 dans une partie de circuit haute fréquence.
